# EUROPÄISCHE PATENTSCHRIFT

(11) **EP 4 149 002 B1**
(45) Veröffentlichungstag und Bekanntmachung des Hinweises auf die Patenterteilung: **09.10.2024**
(21) Anmeldenummer: 22191627.3
(22) Anmeldetag: 23.08.2022
(51) Int. Cl.: H03K 17/96, F24C 7/08

(54) **BEDIENEINRICHTUNG FÜR EIN ELEKTROGERÄT UND ELEKTROGERÄT MIT EINER SOLCHEN BEDIENEINRICHTUNG**
OPERATING DEVICE FOR AN ELECTRIC DEVICE AND ELECTRIC DEVICE WITH SUCH AN OPERATING DEVICE
DISPOSITIF DE COMMANDE POUR UN APPAREIL ÉLECTRIQUE ET APPAREIL ÉLECTRIQUE DOTÉ D'UN TEL DISPOSITIF DE COMMANDE

(30) Priorität: 09.09.2021 DE 102021209964
(43) Veröffentlichungstag der Anmeldung: 15.03.2023
(73) Patentinhaber: E.G.O. Elektro-Gerätebau GmbH, 75038 Oberderdingen (DE)
(72) Erfinder: Gässler, Sandra, 71665 Vaihingen an der Enz (DE)
(74) Vertreter: Patentanwälte Ruff, Wilhelm, Beier, Dauster & Partner mbB

(56) Entgegenhaltungen:
- DE-A1- 102011 112 089
- DE-A1- 102011 119 137
- US-A1- 2010 245 289

## Beschreibung

### Anwendungsgebiet und Stand der Technik

Die Erfindung betrifft eine Bedieneinrichtung für ein Elektrogerät, insbesondere für ein Kochfeld, sowie ein Elektrogerät mit einer solchen Bedieneinrichtung.

Aus der DE 10 2004 044 355 A1 ist eine Bedieneinrichtung mit sogenannten Slidern bekannt. Sie weist in einer Linie angeordnete kapazitive Berührungsschalter auf, die unter einer Kochfeldplatte als Bedienblende angeordnet sind. Sie bilden einen solchen Slider. Jeder kapazitive Berührungsschalter weist einen kapazitiven Berührungsbereich auf. Des Weiteren kann jeder kapazitive Berührungsschalter beleuchtet werden, um einer Bedienperson Informationen anzuzeigen oder den Bedienzustand genau dieses Berührungsschalters.

Aus der DE 10 2016 223 848 A1 ist es bekannt, zwei solcher Slider hintereinander paarweise und mehrere dieser Paare nebeneinander anzuordnen. So ist es möglich, einen solchen Slider einer Kochstelle an dem Kochfeld sozusagen entsprechend zuzuordnen.

Aus der DE 103 52 714 A1 ist eine Bedieneinrichtung bekannt, die einen optischen Berührungsschalter aufweist. Dieser arbeitet nach Art einer Reflex-Lichtschranke mit einem Lichtsender und einem Lichtempfänger. Wird ein Finger in einen optischen Berührungsbereich auf der Bedienblende oberhalb des optischen Berührungsschalters gelegt, insbesondere direkt darüber, so wird von dem Lichtsender ausgestrahltes Licht zurückreflektiert, was der Lichtempfänger erkennt. Eine Steuerung wertet dies als Betätigung.

Aus der US 2010/245289 A1 ist eine Vorrichtung zur optischen Erkennung einer Annäherung und einer Berühreingabe bekannt. Oberhalb einer Bedieneinrichtung für die Berühreingabe kann ein Finger angeordnet werden, dessen Entfernung mit mehreren Reflex-Lichtschranken erkannt wird. Sie weisen jeweils einen Lichtsender auf, dessen abgestrahltes Licht von dem Finger zu einem zentralen, innerhalb der Lichtsender angeordneten Lichtempfänger zurückreflektiert wird. Aus der Entfernung zwischen Finger und dem jeweiligen Lichtsender kann die genaue Position des Fingers erfasst werden.

Aus der DE 10 2011 119 137 A1 und der DE 10 2011 112 089 A1 sind weitere Bedienvorrichtungen bekannt mit ähnlichen optischen Sensoren bzw. Reflex-Lichtschranken zur Erkennung einer Annäherung bzw. Berührung mit einem Finger als Bedienung. Hier ist jeweils zusätzlich zu einer Reflex-Lichtschranke ein kapazitives Sensorelement vorgesehen, um eine Bedienung mit dem Finger besser bzw. genauer erkennen zu können.

### Aufgabe und Lösung

Der Erfindung liegt die Aufgabe zugrunde, eine eingangs genannte Bedieneinrichtung sowie ein damit versehenes Elektrogerät zu schaffen, mit denen Probleme des Standes der Technik gelöst werden und es insbesondere möglich ist, eine Bedieneinrichtung vielfältig und mit zahlreichen Optionen zur Bedienung auszugestalten, wobei vorzugsweise der Aufbau und der dafür notwendige Aufwand möglichst reduziert sind.

Gelöst wird diese Aufgabe durch eine Bedieneinrichtung mit den Merkmalen des Anspruchs 1 sowie durch ein Elektrogerät mit einer solchen Bedieneinrichtung mit den Merkmalen des Anspruchs 14. Vorteilhafte sowie bevorzugte Ausgestaltungen der Erfindung sind Gegenstand der weiteren Ansprüche und werden im Folgenden näher erläutert. Dabei werden manche der Merkmale nur für die Bedieneinrichtung oder nur für das Elektrogerät beschrieben. Sie sollen jedoch unabhängig davon sowohl für eine Bedieneinrichtung als auch für ein Elektrogerät selbständig und unabhängig voneinander gelten können. Der Wortlaut der Ansprüche wird durch ausdrückliche Bezugnahme zum Inhalt der Beschreibung gemacht.

Es ist vorgesehen, dass die Bedieneinrichtung eine Bedienblende aufweist, welche vorteilhaft eine flache Platte ist. Beispielsweise kann sie durch eine Kochfeldplatte gebildet sein, wenn die Bedieneinrichtung in ein Kochfeld als Elektrogerät eingebaut ist. An der Bedienblende sind entlang einer ersten Linie kapazitive Berührungsschalter angeordnet. Die Linie kann gerade verlaufen, kann aber auch gekrümmt oder beliebig verlaufen. Jeder kapazitive Berührungsschalter ist dabei von einem kapazitiven Sensorelement gebildet, das unter der Bedienblende angeordnet ist. Dabei weist jeder kapazitive Berührungsschalter einen kapazitiven Berührungsbereich oben an der Blende über dem kapazitiven Sensorelement auf. Dieser kapazitive Berührungsbereich ist der Bereich, in dem eine Berührung bzw. ein Auflegen eines Fingers auf die Bedienblende noch sicher erkannt werden kann. So kann vorzugsweise als Maß vorgesehen sein, dass eine Signalstärke für ein sicheres Erkennen mindestens 10%, insbesondere mindestens 50%, bis 70% oder bis 80% einer maximalen Signalstärke bzw. derjenigen Signalstärke beträgt, die vorliegt, wenn ein Finger direkt oberhalb des kapazitiven Berührungsschalters bzw. Sensorelements aufgelegt wird. Ein solcher kapazitiver Berührungsbereich kann zwischen 1 cm und 3 cm um die Fläche des kapazitiven Berührungsschalters bzw. Sensorelements herum reichen.

Des Weiteren sind an der Bedieneinrichtung optische Berührungsschalter vorgesehen, die an der Bedienblende angeordnet sind, vorteilhaft darunter angeordnet sind genauso wie die kapazitiven Berührungsschalter. Diese optischen Berührungsschalter sind entlang einer zweiten Linie neben der vorgenannten ersten Linie von kapazitiven Berührungsschaltern angeordnet. Erfindungsgemäß verlaufen die erste Linie und die zweite Linie parallel zueinander, unabhängig von einem geraden oder gebogenen Verlauf. Jeder optische Berührungsschalter weist einen optischen Berührungsschalter oben an der Bedienblende auf. Für diesen optischen Berührungsbereich gilt grundsätzlich dasselbe wie für den kapazitiven Berührungsbereich, hier kann eine Betätigung bzw. Bedienung durch Auflegen eines Fingers sicher erkannt werden. Vorteilhaft ist dabei der optische Berührungsbereich kleiner bzw. geringer ausgedehnt als der kapazitive Berührungsbereich. So kann er zwischen 20% und 80%, insbesondere zwischen 40% und 60%, der Größe des kapazitiven Berührungsbereichs betragen, und zwar entweder eindimensional in eine Richtung gesehen oder zweidimensional auf einen Durchmesser des Bereichs bezogen. So kann der optische Berührungsbereich zumindest in einer Richtung gesehen deutlich vom kapazitiven Berührungsbereich unterschieden werden, beispielsweise auch sozusagen versetzt sein. Die beiden genannten Linien können dabei einen Abstand zwischen 1 mm und 30 mm voneinander aufweisen bzw. dieser Abstand kann in einer Richtung rechtwinklig zu den Linien zwischen benachbart angeordneten optischen Berührungsschaltern und kapazitiven Berührungsschaltern liegen.

Des Weiteren ist als Besonderheit vorgesehen, dass ein Abstand zwischen benachbarten optischen Berührungsschaltern entlang der zweiten Linie gleich ist oder größer ist als ein Abstand zwischen den benachbarten kapazitiven Berührungsschaltern entlang der ersten Linie. Dabei ist insgesamt vorteilhaft vorgesehen, dass auf der gesamten Linie, entlang welcher funktional zusammengehörend kapazitive Berührungsschalter bzw. optische Berührungsschalter angeordnet sind, weniger optische Berührungsschalter angeordnet sind als kapazitive Berührungsschalter. Somit ist vorteilhaft der Abstand zwischen benachbarten optischen Berührungsschaltern entlang derselben Linie größer als zwischen benachbarten kapazitiven Berührungsschaltern entlang derselben Linie, bevorzugt mindestens doppelt so groß. So kann Aufwand für optische Berührungsschalter eingespart werden, die weggelassen werden können, was Kosten und möglicherweise auch Platz auf einem Bauteilträger einsparen kann, auf dem die Berührungsschalter angeordnet sind.

Bei der Erfindung kann vorteilhaft genutzt werden, dass ggf. die kapazitiven Berührungsbereiche größer sind als die optischen Berührungsbereiche. So kann vorgesehen sein, dass entlang der ersten Linie mit kapazitiven Berührungsschaltern kein Betätigen innerhalb eines optischen Berührungsbereichs erfolgt, die optischen Berührungsschalter hier also nicht arbeiten bzw. nichts erkennen. Anders kann es sein entlang der zweiten Linie mit optischen Berührungsschaltern, ein Betätigen bzw. ein Auflegen eines Fingers auf die Bedienblende oberhalb davon kann hier sowohl in einem der optischen Berührungsbereiche liegen, was selbstverständlich ist, als auch in einem kapazitiven Berührungsbereich von der benachbarten Linie. Besonders vorteilhaft kann hier vorgesehen sein, dass die kapazitiven Berührungsbereiche der kapazitiven Berührungsschalter der ersten Linie entlang der gesamten zweiten Linie überlappen, insbesondere die gesamte zweite Linie lückenlos überdecken. Die kapazitiven Berührungsschalter der ersten Linie erkennen also sowohl ein Betätigen entlang der ersten Linie als auch entlang der benachbarten zweiten Linie. Die optischen Berührungsschalter dagegen erkennen nur ein Betätigen entlang der zweiten Linie und nicht entlang der ersten Linie. Somit kann ein Betätigen entlang der ersten Linie durch Auswertung sämtlicher Berührungsschalter erkannt werden, wobei von den optischen Berührungsschaltern der zweiten Linie eben kein Signal kommt. Wenn von diesen optischen Berührungsschaltern kein Signal kommt und kein Betätigen erkannt wird, liegt ein Betätigen entlang der ersten Linie vor. Erkennen die optischen Berührungsschalter der zweiten Linie dagegen auch eine Betätigung, selbst wenn diese nicht ausreicht für eine genaue Lokalisierung entlang der Linie, so liegt zwangsläufig eine Betätigung entlang der zweiten Linie vor. Die genaue Betätigung bzw. Lokalisierung erfolgt durch Auswertung sowohl der optischen Berührungsschalter als auch der kapazitiven Berührungsschalter, die jeweils ein Signal erfasst haben. Auch hier kann jedoch davon ausgegangen werden, dass die höhere Genauigkeit durch die Auswertung der kapazitiven Berührungsschalter erfolgt.

Es kann beispielsweise vorgesehen sein, dass die kapazitiven Berührungsbereiche mindestens 25%, vorzugsweise mindestens 50%, des Abstands der beiden Linien über diese zweite Linie hinaus reichen. So ist eben eine gute Abdeckung einer Betätigung entlang der zweiten Linie durch die kapazitiven Berührungsschalter der ersten Linie möglich. Vorteilhaft verläuft die zweite Linie mit den optischen Berührungsschaltern hinter der ersten Linie mit den kapazitiven Berührungsschaltern, vorzugsweise von der Vorderkante eines Elektrokochfelds als Elektrogerät gesehen. Hinter dieser zweiten Linie mit optischen Berührungsschaltern verläuft vorteilhaft eine dritte Linie mit Berührungsschaltern, wobei diese Berührungsschalter wiederum kapazitiv ausgebildet sind. In dieser dritten Linie können vorteilhaft genauso viele kapazitive Berührungsschalter angeordnet sein wie in der ersten Linie bzw. sie können auch denselben Abstand wie diejenigen in der ersten Linie aufweisen. Dabei kann allgemein vorgesehen sein, dass die kapazitiven Berührungsschalter nicht nur innerhalb der Linien, sondern auch in allen Linien der Bedieneinrichtung gleichen Abstand aufweisen, wenn sie zu dieser Linie gehören bzw. funktional zusammengehören. In ähnlicher Form können sämtliche optischen Berührungsschalter den jeweils gleichen Abstand aufweisen. In alternativer Ausgestaltung kann auch vorgesehen sein, dass zwischen zwei Linien mit kapazitiven Berührungsschaltern zwar eine Linie vorgesehen ist, an der das Auflegen eines Fingers erkannt werden kann und als spezifische Bedienung erkannt und ausgewertet sowie umgesetzt werden kann. Entlang dieser Linie müssen aber nicht zwingend optische Berührungsschalter vorgesehen sein, das Auflegen eines Fingers zwischen zwei kapazitiven Berührungsschaltern und somit auch entlang einer Linie zwischen zwei Linien mit kapazitiven Berührungsschaltern kann auch so ausreichend genau erkannt werden, wie nachfolgend noch näher erläutert wird.

In Weiterbildung der Erfindung kann vorgesehen sein, dass sämtliche kapazitiven Berührungsschalter gleich bzw. sogar identisch ausgebildet sind. Auch dies kann für die optischen Berührungsschalter gelten.

In nochmaliger weiterer Ausbildung der Erfindung kann hinter der vorgenannten dritten Linie mit kapazitiven Berührungsschaltern eine weitere vierte Linie mit optischen Berührungsschaltern verlaufen, vorteilhaft wiederum parallel zueinander. Auch für diese vierte Linie mit optischen Berührungsschaltern gilt vorteilhaft das zuvor Bemerkte hinsichtlich Abstand und Ausbildung der optischen Berührungsschalter. Im Hinblick auf die vorherigen Ausführungen zu einem möglichen Weglassen von optischen Berührungsschaltern zwischen kapazitiven Berührungsschaltern oder zwischen zwei Linien von kapazitiven Berührungsschaltern ist zu sagen, dass entlang dieser vierten Linie die optischen Berührungsschalter dann notwendig sind, wenn dahinter keine fünfte Linie mit kapazitiven Berührungsschaltern vorgesehen ist. Ansonsten könnten die optischen Berührungsschaltern entlang der vierten Linie wiederum weggelassen werden, und es könnte dennoch eine Bedienung an Stellen entlang der vierten Linie erkannt werden, wie dies zuvor erläutert worden ist.

In möglicher Ausgestaltung der Erfindung können entlang der ersten Linie mit kapazitiven Berührungsschaltern zwischen 5 und 15 kapazitive Berührungsschalter bzw. kapazitive Sensorelemente angeordnet sein. Diese Linie kann zwischen 4 cm und 20 cm lang sein, grundsätzlich ist die Länge der Linie aber nicht limitiert.

In weiterer Ausgestaltung der Erfindung können entlang einer Linie mit optischen Berührungsschaltern grundsätzlich beliebig viele Berührungsschaltern angeordnet sein, vorteilhaft zwischen 2 und 7 optische Berührungsschalter angeordnet sein. Besonders vorteilhaft sind weniger als halb so viele optische Berührungsschalter entlang der zweiten Linie angeordnet wie kapazitive Berührungsschalter entlang der ersten Linie. Ein Abstand der Linien kann vorteilhaft zwischen 10 mm und 20 mm liegen.

Funktional können die Linien von Berührungsschaltern auch dadurch definiert sein, dass sie einen vorgenannten Slider bilden können. Weitere Berührungsschalter, die in derselben Linie bzw. in deren Verlängerung liegen, aber nicht zu der Einstellung dieser Funktion dienen oder benötigt werden, zählen dann nicht zu der Linie bzw. zu einem davon gebildeten Slider. Sie weisen zu der Linie von kapazitiven Berührungsschaltern vorteilhaft einen größeren Abstand auf als die Berührungsschalter innerhalb der Linie, besonders vorteilhaft ist der Abstand zueinander mindestens doppelt so groß.

In Ausgestaltung der Erfindung sind die kapazitiven Sensorelemente vorteilhaft als elektrisch leitfähige Flächen unterhalb der Bedienblende ausgebildet bzw. weisen solche elektrisch leitfähigen Flächen auf. Einerseits ist es zwar möglich, diese Flächen an der Unterseite der Bedienblende anzubringen, beispielsweise durch direktes Beschichten oder Aufkleben. Bevorzugt werden jedoch separate Bauteile verwendet, die unter der Bedienblende angeordnet sind oder an die Unterseite der Bedienblende angedrückt bzw. angelegt sind. Dies können beispielsweise die Oberseiten von kastenartigen Bauteilen sein, die innen Leuchtmittel enthalten. Beispielhaft wird hier auf die DE 102015203209 A1 verwiesen.

In Ausgestaltung der Erfindung können die optischen Berührungsschalter vorteilhaft als sogenannte Reflex-Lichtschranken ausgebildet sein und dazu mindestens einen Lichtsender und mindestens einen Lichtempfänger aufweisen, vorteilhaft jeder optische Berührungsschalter genau einen Lichtsender und genau einen Lichtempfänger. Dabei sind bevorzugt alle optischen Berührungsschalter gleich ausgebildet, wobei Lichtsender und Lichtempfänger in einem Bauteilgehäuse angeordnet sein können, wie dies aus dem eingangs genannten Stand der Technik hervorgeht. In vorteilhafter Ausgestaltung der Erfindung sind Lichtsender und Lichtempfänger eines optischen Berührungsschalters in einer Richtung entlang der Linie mit optischen Berührungsschaltern vorgesehen, besonders vorteilhaft verläuft diese Linie genau durch die Mittelpunkte der abwechselnden Anordnung von Lichtempfänger und Lichtsender. Dadurch kann erreicht werden, dass ihr optischer Berührungsbereich in einer Richtung entlang der Linie größer ist als in einer Richtung quer zur Linie. So kann ein Überlappen hin zur Linie mit kapazitiven Berührungsschaltern nochmals besser vermieden werden.

Die optischen Berührungsschalter können vorteilhaft mit Licht im nicht-sichtbaren Bereich arbeiten, vorteilhaft mit IR-Licht. So sind sie im Betrieb nicht sichtbar, des Weiteren ist ihre Auswertung sicherer gegenüber Störungen durch Licht in dem Bereich, in dem das Elektrogerät mit der Bedieneinrichtung angeordnet ist.

Es ist möglich in einer Ausgestaltung der Erfindung, dass vor der ersten Linie mit kapazitiven Berührungsschaltern in einer Linie, die vorteilhaft parallel dazu verläuft, Leuchtanzeigen und/oder auf die Bedienblende aufgedruckte Symbole oder Zeichen angeordnet sind. Vor dieser Linie wiederum kann eine weitere Vor-Linie mit kapazitiven Berührungsschaltern angeordnet sein, die wiederum parallel dazu verläuft. Es ist möglich, dass ein Abstand zwischen der ersten Linie mit kapazitiven Berührungsschaltern und der Linie mit den Leuchtanzeigen bzw. Symbolen gleich groß ist wie der Abstand dieser Leuchtanzeigen bzw. Symbole zu der Vor-Linie mit kapazitiven Berührungsschaltern. Dadurch kann nochmals eine vorteilhafte Erweiterung der Funktionalität der Bedieneinrichtung erreicht werden. Die Linie mit den Leuchtanzeigen bzw. Symbolen oder Zeichen verläuft also zwischen der ersten Linie mit kapazitiven Berührungsschaltern und der Vor-Linie mit kapazitiven Berührungsschaltern.

Bei der Erfindung ist vorteilhaft vorgesehen, dass die Bedieneinrichtung von vorne beginnend zwingend eine Linie mit kapazitiven Berührungsschaltern als vorderste Linie aufweist, sei es die vorgenannte erste Linie oder die zuvor beschriebene Vor-Linie. So kann hier eine genaue Erkennung einer Bedienung sichergestellt werden, und vorteilhaft kann dahinter eine Linie mit optischen Berührungsschaltern vorgesehen sein.

Die Steuerung der Bedieneinrichtung, vorteilhaft ausgebildet als Mikrocontroller, ist so ausgebildet, dass sie bei einer Betätigung bzw. einer Berührung mit einem Finger an der Bedienblende oberhalb eines kapazitiven Berührungsschalters, also in dessen kapazitivem Berührungsbereich, der entlang der ersten Linie erfolgt, an keinem in der Linie daneben angeordneten optischen Berührungsschalter eine Betätigung bzw. eine Berührung in deren optischem Berührungsbereich erkennt. Bei einer Betätigung bzw. einer Berührung mit einem Finger an der Bedienblende oberhalb eines optischen Berührungsschalters dagegen, also in dessen optischem Berührungsbereich entlang der zweiten Linie, erkennt die Steuerung eine Berührung bzw. Betätigung in einem kapazitiven Berührungsbereich in der Linie von daneben angeordneten, insbesondere direkt daneben angeordneten, kapazitiven Berührungsschaltern. Somit erkennt im zweiten Fall die Steuerung anhand der Signale mindestens eines optischen Berührungsschalters und mindestens eines kapazitiven Berührungsschalters, dass eine Berührung in oder entlang dieser zweiten Linie erfolgt ist. Befindet sich eine Linie mit optischen Berührungsschaltern zwischen zwei Linien mit kapazitiven Berührungsschaltern, so kann vorteilhaft vorgesehen sein, dass die kapazitiven Berührungsbereiche beider Linien mit kapazitiven Berührungsschaltern über die Linie mit optischen Berührungsschaltern überlappen bzw. reichen. Dann kann eine Betätigung entlang der Linie mit optischen Berührungsschaltern nicht nur von einem optischen Berührungsschalter und einem kapazitiven Berührungsschalter erkannt werden, sondern sogar von zwei kapazitiven Berührungsschaltern unterschiedlicher Linien. Dies kann bevorzugt für eine nochmals sicherere Betätigung entlang der Linie mit optischen Berührungsschaltern verwendet werden. Es ist also sogar noch ein Vorteil.

Abstände zwischen kapazitiven Berührungsschaltern bzw. ihren kapazitiven Sensorelementen entlang einer ihrer Linien können zwischen 0 mm und 20 mm entlang der Linie betragen. Vorteilhaft betragen sie zwischen 2 mm und 10 mm. Somit stoßen die kapazitiven Berührungsschalter bzw. ihre Sensorelemente nicht direkt aneinander an, weisen aber auch nur einen Abstand von wenigen Millimetern zueinander auf. So ist eine genaue Erkennung möglich. Das Auflegen eines Fingers auf einer Linie mit kapazitiven Berührungsschaltern wird in der Regel von mehreren benachbarten kapazitiven Berührungsschaltern erkannt bzw. löst hier Signale aus. Die vorgenannte Steuerung der Bedieneinrichtung kann dies bekanntermaßen jedoch genau lokalisieren, indem sie bestimmt, an welchem Berührungsschalter ein maximales Signal erzeugt wird bzw. anliegt.

Die Abstände zwischen den optischen Berührungsschaltern bzw. zwischen Lichtsender und Lichtempfänger benachbarter optischer Berührungsschalter sind vorteilhaft größer als vorgenannt für die kapazitiven Berührungsschalter. So kann deren Abstand zwischen 10 mm und 40 mm betragen, vorteilhaft zwischen 20 mm und 30 mm. Dabei ist auch zu bemerken, dass in der Regel die flächenmäßige Ausdehnung eines kapazitiven Berührungsschalters bzw. seines kapazitiven Sensorelements größer ist als diejenige von Lichtsender und Lichtempfänger eines optischen Berührungsschalters.

Ein Elektrogerät weist eine erfindungsgemäße Bedieneinrichtung auf an einer Bedienblende, die vorteilhaft eine Oberseite oder eine Vorderseite des Elektrogeräts ist. Besonders vorteilhaft ist das Elektrogerät ein Kochfeld, insbesondere ein Elektrokochfeld bzw. mit elektrisch betriebenen Heizeinrichtungen versehen. Die Bedienblende wird dann durch die Kochfeldplatte des Kochfelds gebildet. Möglicherweise kann die Bedieneinrichtung auch eine eigene Bedienblende aufweisen, die dann in der Ebene der Kochfeldplatte bzw. mit derselben Oberseite wie die Kochfeldplatte verlaufen sollte.

Bevorzugt ist vorgesehen, dass die Linien von Berührungsschaltern parallel zu einer Kante der Bedienblende verlaufen. Dabei können sie parallel zu einer Vorderkante der Kochfeldplatte verlaufen. Es können, wie eingangs erläutert worden ist, auch mehrere Gruppen von hintereinander angeordneten Linien von Berührungsschaltern nebeneinander angeordnet sein. Deren Linien können dann jeweils in Verlängerung zueinander angeordnet sein, dies muss aber nicht so sein.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in Zwischen-Überschriften und einzelne Abschnitte beschränkt die unter diesen gemachten Aussagen nicht in ihrer Allgemeingültigkeit.

### Kurzbeschreibung der Zeichnungen

Ausführungsbeispiele der Erfindung sind in den Zeichnungen schematisch dargestellt und werden im Folgenden näher erläutert. In den Zeichnungen zeigen:
- Fig. 1: eine Draufsicht auf ein erfindungsgemäßes Kochfeld von oben mit zwei erfindungsgemäßen Bedieneinrichtungen,
- Fig. 2: eine erfindungsgemäße Bedieneinrichtung entsprechend Fig. 1 in Vergrößerung, die vier Slider aufweist mit jeweils Berührungsschaltern entlang einer Linie,
- Fig. 3: eine Schnittdarstellung und eine Draufsicht eines optischen Berührungsschalters mit einer Reflex-Lichtschranke und mit einem optischen Berührungsbereich,
- Fig. 4: eine Schnittdarstellung und eine Draufsicht eines kapazitiven Berührungsschalters mit einem kapazitiven Berührungsbereich und
- Fig. 5: eine vergrößerte Ansicht der Bedieneinrichtung aus Fig. 2 mit zwei kapazitiven Slidern und einem optischen Slider dazwischen, wobei jeweils gestrichelt die Position der Berührungsschalter dargestellt ist und durchgezogen jeweilige Berührungsbereiche dargestellt sind.

### Detaillierte Beschreibung der Ausführungsbeispiele

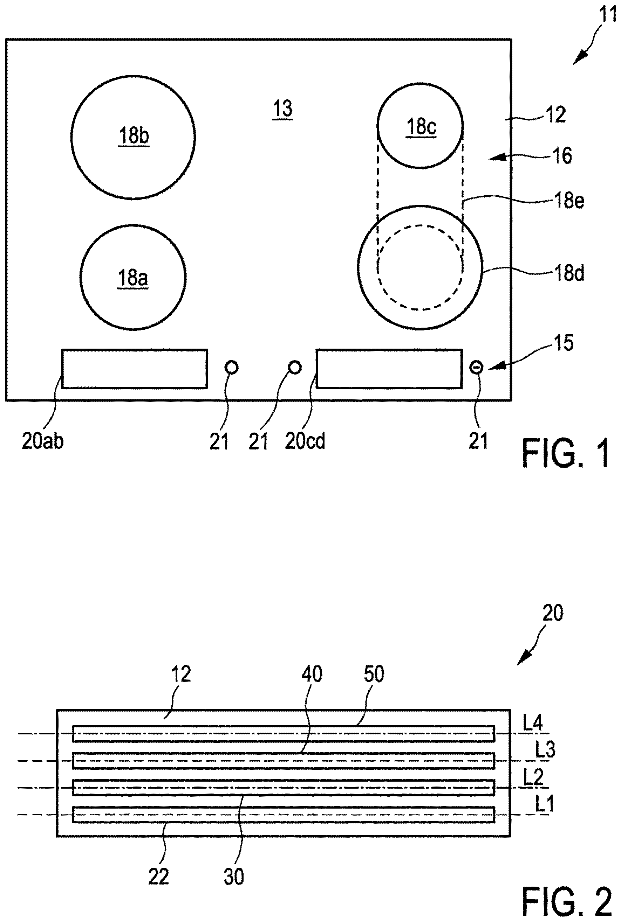

In der Fig. 1 ist in Draufsicht ein erfindungsgemäßes Kochfeld 11 als Induktionskochfeld dargestellt. Es weist eine Kochfeldplatte 12 auf, vorteilhaft aus Glaskeramik, wobei die Kochfeldplatte 12 eine Oberseite 13 und eine Unterseite 14 aufweist. Ein hinterer großer Bereich des Kochfelds 11 bzw. der Kochfeldplatte 12 bildet einen Heizbereich, in dem vier Induktionsheizspulen 18a bis 18d unter der Kochfeldplatte 12 angeordnet sind. Die beiden Induktionsheizspulen 18c und 18d können durch eine gestrichelt dargestellte weitere Induktionsheizspule 18e zu einer sogenannten Bräter-Zone zusammengeschaltet werden. Auf die Zusammenschaltung wird nachfolgend noch eingegangen.

In einem vorderen Bedienbereich 15, der also den vorderen und kleineren Bereich der Kochfeldplatte 12 einnimmt und der nicht zum Heizbereich 16 gehört, sind links eine Bedieneinrichtung 20ab und rechts eine Bedieneinrichtung 20cd angeordnet. Diese sind identisch ausgebildet, sie werden nachfolgend noch im Detail und ausführlich beschrieben. Zwischen den beiden Bedieneinrichtungen 20ab und 20cd sind zwei einzelne Bedienelemente 21 angeordnet, vorteilhaft ausgebildet als Berührungsschalter, insbesondere als kapazitive Berührungsschalter. Mit ihnen können Zusatzfunktionen eingestellt werden, beispielsweise das vorgenannte Zusammenschalten der beiden Induktionsheizspulen 18c und 18d mit der Induktionsheizspule 18e als lange Bräter-Zone. Das Bedienelement 21 ganz rechts ist ein Ein-/Aus-Schalter. Es ist vorteilhaft genauso ausgebildet wie die anderen beiden Bedienelemente 21.

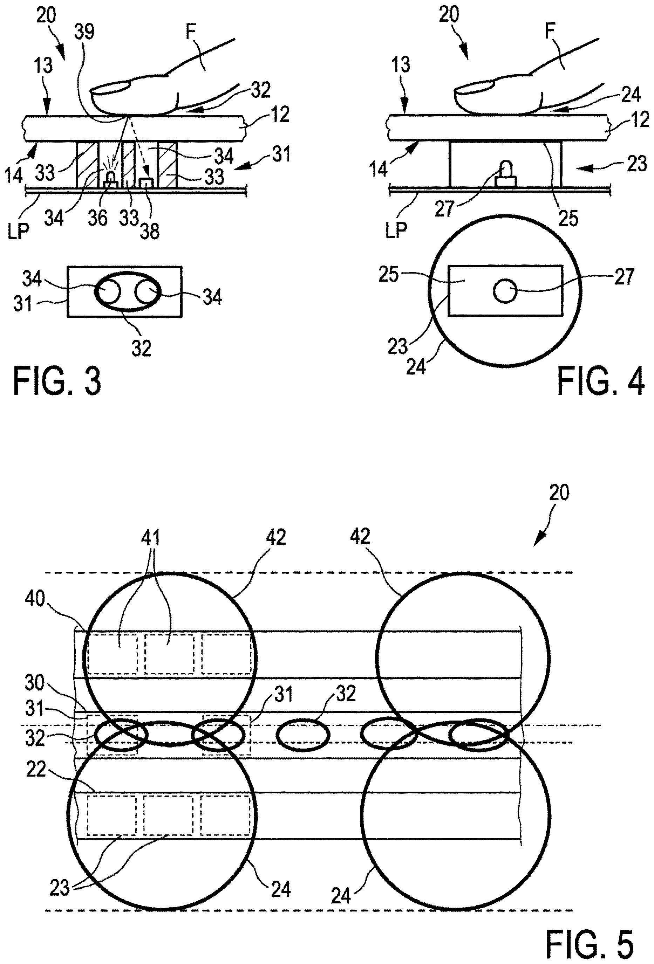

In der vergrößerten Darstellung der Fig. 2 ist eine erfindungsgemäße Bedieneinrichtung 20 dargestellt. Sie weist eine Bedienblende auf, welche hier von der Kochfeldplatte 12 gebildet wird, wie nachfolgend die Fig. 3 und 4 noch deutlich zeigen. Die Bedieneinrichtung 20 weist vier gerade und parallele Streifen mit jeweils gleichem Abstand zueinander auf, die entlang von Linien laufen. Der vorderste Streifen ist ein erster kapazitiver Slider 22, der entlang der gestrichelten Linie L1 verläuft. Dahinter ist ein zweiter optischer Slider 30 angeordnet, der entlang einer strichpunktierten Linie L2 verläuft. Wiederum dahinter ist ein dritter kapazitiver Slider 40 angeordnet, der entlang einer gestrichelten Linie L3 verläuft. Dahinter wiederum ist ein vierter optischer Slider 50 angeordnet, der entlang einer strichpunktierten Linie L4 verläuft. Sowohl der dritte kapazitive Slider 40 als auch vor allem der vierte optische Slider 50 müssen nicht zwingend vorgesehen sein, beim dritten kapazitiven Slider 40 ist es aber von Vorteil. So kann beispielsweise vorgesehen sein, dass am vorderen ersten kapazitiven Slider 22 eine Leistung für eine der vorderen Induktionsheizspulen 18a bzw. 18d eingestellt werden kann, und zwar direkt. Am hinteren dritten kapazitiven Slider 40 kann eine Leistung für eine der hinteren Induktionsheizspulen 18b oder 18c direkt eingestellt werden. An dem dazwischenliegenden zweiten optischen Slider 30 können Zusatzfunktionen eingestellt werden wie beispielsweise eine Timer-Eingabe odgl.. Dies gilt dann auch für den vierten optischen Slider 50. Die Durchnummerierung aller Slider dient dazu, diese in der folgenden Beschreibung besser auseinanderhalten zu können.

An der Kochfeldplatte 12 als Bedienblende können natürlich noch Symbole oder weitere Leuchtanzeigen vorgesehen sein, insbesondere auch innerhalb bzw. oberhalb der Slider oder neben diesen. Dies wird im Nachfolgenden dargestellt und erläutert.

In der Fig. 3 ist bei der erfindungsgemäßen Bedieneinrichtung 20 ein optischer Berührungsschalter 31 für beispielsweise den zweiten optischen Slider 30 der Fig. 2 oben in Schnittdarstellung und unten in Draufsicht dargestellt. Der optische Berührungsschalter 31 weist darüber einen optischen Berührungsbereich 32 auf, der in Fig. 3 mit einer dick durchgezogenen Linie dargestellt ist. Seine Form entspricht in etwa einem Oval. Wenn ein Finger F oberhalb des optischen Berührungsschalters 31 und im optischen Berührungsbereich 32 auf die Oberseite 13 der Kochfeldplatte 12 als Bedienblende aufgelegt ist, so erfolgt eine Betätigung. Dazu weist der optische Berührungsschalter 31 ein Gehäuse 33 mit zwei Lichtkanälen 34 darin auf. Im linken Lichtkanal 34 ist eine LED 36 als Lichtsender angeordnet, und im rechten Lichtkanal 34 ist ein Lichtempfänger 38 angeordnet. Wie dargestellt ist, strahlt die LED 36 Licht nach oben aus, vorteilhaft IR-Licht, was von einem aufgelegten Finger F in einem Reflexionsbereich 39, der innerhalb des optischen Berührungsbereichs 32 liegen muss, auf bekannte Art und Weise nach unten reflektiert wird. Das gestrichelt dargestellte reflektierte Licht fällt auf den Lichtempfänger 38, der dies erkennt. Eine Steuerung der Bedieneinrichtung 20 oder des Kochfelds 11, an die der optische Berührungsschalter 31 angeschlossen ist, erkennt diese Bedienung bzw. Betätigung und löst einen entsprechenden Vorgang aus. Wird der Finger F außerhalb des optischen Berührungsbereichs 32 aufgelegt bzw. so, dass gar kein Licht oder wenig Licht, das unterhalb eines vordefinierten Grenzwerts liegt, von der LED 36 durch Reflexion an den Lichtempfänger 38 gegeben wird, so wird keine Bedienung erkannt. Dies ist aber bekannt von derartigen Reflex-Lichtschranken, und auf diese allgemeine Funktion wird auch hier verwiesen.

Die Draufsicht auf den optischen Berührungsschalter 31 gemäß Fig. 3 zeigt, dass der optische Berührungsbereich in etwa um die beiden Lichtkanäle 34 verläuft und deswegen eine längliche bzw. ovale Form aufweist. Je nach Ausgestaltung des optischen Berührungsschalters 31 könnte der optische Berührungsbereich auch größer sein, dann wäre aber möglicherweise die Störanfälligkeit auch größer.

In der Fig. 4 ist ähnlich wie in Fig. 3 eine Schnittdarstellung durch die erfindungsgemäße Bedieneinrichtung 20 dargestellt, allerdings mit einem kapazitiven Berührungsschalter 23. Er weist an seiner Oberseite ein rechteckiges kapazitives Sensorelement 25 auf, das beispielsweise aus Metall oder elektrisch leitfähigem Kunststoff besteht und an die Leiterplatte LP elektrisch kontaktiert ist. In einem Gehäuse odgl. des kapazitiven Berührungsschalters 23 ist eine LED 27 angeordnet, die durch eine entsprechende Öffnung oder lichtdurchlässiges Material des kapazitiven Sensorelements 25 nach oben hindurchleuchten kann. Das kapazitive Sensorelement 25 ist auf bekannte Art und Weise an die Unterseite 14 der Kochfeldplatte 12 als Bedienblende angedrückt. Wird ein Finger F auf die Oberseite 13 aufgelegt oberhalb des kapazitiven Sensorelements 25 bzw. des kapazitiven Berührungsschalters 23, so kann dies erkannt werden. Aus der unteren Draufsicht ist zu erkennen, dass das kapazitive Sensorelement 25 einen kapazitiven Berührungsbereich 24 bildet, der erheblich größer ist als es selbst sowie erheblich größer ist als der optische Berührungsbereich 32 aus der Fig. 3. Möglicherweise ist der kapazitive Berührungsbereich 24 auch nicht angenähert kreisrund, wie dargestellt, sondern etwas länglich entlang der Längsachse des kapazitiven Sensorelements 25. Wichtig ist aber auf alle Fälle, dass der kapazitive Berührungsbereich 24 groß oder sehr groß ist. Er kann beispielsweise dadurch als definiert angesehen werden, dass das Auflegen eines Fingers F innerhalb dieses Bereichs eine eingangs genannte Signaländerung von mindestens 10 % oder 50 % bewirkt. Seine Fläche kann erkennbar größer sein als der optische Berührungsbereich 32, vorteilhaft 10mal bis 30mal so groß sein wie der optische Berührungsbereich 32.

In der Fig. 5 ist ein vergrößerter Ausschnitt der Bedieneinrichtung 20 entsprechend Fig. 2 dargestellt mit dem vorderen kapazitiven Slider 22, dem zweiten optischen Slider 30 und dahinter dem dritten kapazitiven Slider 40. Der vierte Slider ist der Übersichtlichkeit halber nicht dargestellt. Gestrichelt dargestellt sind kapazitive Berührungsschalter 23 bzw. 41 entlang der beiden kapazitiven Slider 22 und 40. Sie sind relativ nah beieinander bzw. stoßen nahezu aneinander an. Ihr Abstand kann zwischen 0,5 mm und 10 mm variieren, vorteilhaft maximal 5 mm betragen. Für den mittlere der drei dargestellten gestrichelten kapazitiven Berührungsschalter 23 ist der kapazitive Berührungsbereich 24 dargestellt, ebenso wie für einen nicht dargestellten kapazitiven Berührungsschalter ziemlich weit rechts entlang des ersten kapazitiven Sliders 22. Stellt man sich sämtliche kapazitiven Berührungsbereiche 24 entlang des ersten kapazitiven Sliders 22 vor, so ergibt sich eine Art Streifen, entlang dessen oder innerhalb dessen das Auflegen eines Fingers F erkannt werden kann. Dieser Streifen wird oben und unten durch die strichpunktierte Linien begrenzt. Überall entlang dieses Streifens bzw. innerhalb dieses Streifens kann die Bedieneinrichtung 20 das Auflegen eines Fingers F erkennen.

Wie gut zu erkennen ist, überlappt der Streifen ein Stück über den zweiten optischen Slider 30 dahinter. Dieses Überlappen könnte auch noch voll über diesen darüber gehen oder mit der oberen Kante abschließen. Dadurch wird deutlich, dass das Auflegen eines Fingers F, was ja schließlich eine gewisse Fläche bzw. Ausdehnung hat, welche in etwa dem hier dargestellten optischen Berührungsbereichen 32 entspricht, stets auch innerhalb des Streifens und somit innerhalb eines der kapazitiven Berührungsbereiche 24 erfolgt. So kann also, wie eingangs erläutert worden ist, das Auflegen eines Fingers F über dem zweiten optischen Slider 30 mit den gestrichelt dargestellten optischen Berührungsschaltern 31 vom ersten kapazitiven Slider 22 erkannt werden, und zwar sowohl absolut als auch in etwa an welcher Stelle bzw. welchem kapazitiven Berührungsschalter 23 zugehörig.

Wie deutlich zu erkennen ist, ist der Abstand zwischen zwei benachbarten optischen Berührungsschaltern 31 deutlich größer als bei den beiden kapazitiven Slidern 22 und 40. Entsprechend sind optische Berührungsbereiche 32 nur mit Abständen und nicht nahtlos durchgehend vorgesehen. Insgesamt kann vorgesehen sein, dass entlang des zweiten optischen Sliders 30 in etwa halb so viele oder etwas weniger optische Berührungsschalter 31 vorgesehen sind wie entlang des ersten kapazitiven Sliders 22 und entlang des dritten kapazitiven Sliders 40. So kann eine Einsparung an optischen Berührungsschaltern 31 erreicht werden.

Da der hintere dritte kapazitive Slider 40 identisch zu dem ersten kapazitiven Slider 22 ganz vorne ausgebildet ist, sind auch hier zahlreiche kapazitive Berührungsbereiche 42 vorgesehen, die innerhalb eines gestrichelt dargestellten breiten Streifens verlaufen. Dieser überlappt spiegelbildlich von hinten her über einen großen Teil des zweiten optischen Sliders 30.

Wird ein Finger F nur oberhalb eines der kapazitiven Slider 22 oder 40 aufgelegt, so wird dies offensichtlich nur von dem jeweiligen Slider erkannt bzw. von dessen kapazitiven Berührungsschaltern. Entlang der Länge der Linien L der Slider befindet sich ein Finger F dann im Bereich mehrerer kapazitiver Berührungsbereiche 24 bzw. 42, dies kann eine Steuerung aber leicht unterscheiden und daraus eine genaue Fingerposition ermitteln. Der Vorteil dieser Anordnung ist auch der, was eindeutig zu ersehen ist, dass die beiden kapazitiven Slider 22 und 40 derart weit auseinanderliegen, dass sich ihre kapazitiven Berührungsbereiche 24 bzw. 42 zwar teilweise überlappen. Eine Bedienung mit einem Finger F oberhalb oder an einem der Slider 22 bzw. 40 wird aber eindeutig nur von diesem und von keinem anderen erkannt.

Wird ein Finger F oberhalb des zweiten optischen Sliders 30 auf die Bedienblende bzw. die Kochfeldplatte 12 oder deren Oberseite 13 aufgelegt, beispielsweise oberhalb des ganz links dargestellten optischen Berührungsbereichs 32, so erkennt dies natürlich der darunterliegende optische Berührungsschalter 31. Des Weiteren erkennt es aber mindestens ein kapazitiver Berührungsschalter 23 des unteren ersten kapazitiven Sliders 22 und mindestens ein kapazitiver Berührungsschalter 41 des oberen dritten kapazitiven Sliders 40. Da vom zweiten optischen Slider 30 bzw. eines seiner optischen Berührungsschalter 32 ein Signal kommt, weiß die Steuerung, dass an diesem eine Bedienung erfolgt. Es kann also ausgeschlossen werden, dass an einem der beiden kapazitiven Slider 22 oder 40 eine gewünschte Bedienung erfolgt. Eine weitere Überprüfung ist dadurch möglich, dass von kapazitiven Berührungsschaltern 23 und 41 beider kapazitiver Slider 22 und 40 ein Signal kommt, so dass die Bedienung in der Mitte dazwischen erfolgt sein muss, also auch wiederum zwingend am zweiten optischen Slider 30. Der genaue Ort der Bedienung kann möglicherweise sowohl von einem entsprechenden optischen Berührungsschalter 31, wenn gerade er bzw. wenn gerade sein optischer Berührungsbereich 32 überdeckt ist, als auch von den beiden kapazitiven Slidern 22 und 40 bzw. deren kapazitiven Berührungsschaltern 23 und 41 bestimmt werden.

Wird nun für eine sogenannte Slider-Bedienung der Finger F entlang des zweiten optischen Sliders 30 bewegt, so befindet er sich zwar nicht permanent in einem der optischen Berührungsbereiche 32 der optischen Berührungsschalter 31. Er wird diese aber immer wieder mit etwas zeitlichem Abstand überdecken, und da zusätzlich mindestens einer der benachbarten kapazitiven Slider 22 bzw. 40 eine Bedienung erkennt, erkennt die Steuerung, dass diese Bedienung entlang des zweiten optischen Sliders 30 erfolgen muss.

Hinter dem dritten kapazitiven Slider 40 kann dann entsprechend der Fig. 2 entlang einer parallelen Linie, möglicherweise auch erneut mit gleichem Abstand, ein vierter optischer Slider 50 vorgesehen sein.

Ein weiterer Vorteil der erfindungsgemäßen abwechselnden Anordnung von Linien mit kapazitiven Berührungsschaltern einerseits und optischen Berührungsschaltern andererseits ist der, dass die Linien mit kapazitiven Berührungsschaltern jeweils größeren Abstand zueinander aufweisen können. Sie stören sich somit kaum oder sogar gar nicht, wenn sie selbst direkt betätigt werden. Deswegen sollte der Abstand zwischen Linien mit kapazitiven Berührungsschaltern mindestens so groß sein wie der halbe Durchmesser eines kapazitiven Berührungsbereichs. Durch die dazwischen angeordneten optischen Berührungsschalter kann sozusagen eine räumliche Verdichtung der möglichen Bedienfunktionen erreicht werden.

Auf einer Oberseite 13 der Kochfeldplatte 12 können auch Symbole odgl. aufgebracht oder aufgedruckt werden, die einer Bedienperson veranschaulichen, welche Funktion durch entsprechende Bedienung ausgelöst werden kann. Dies ist aber grundsätzlich aus dem Stand der Technik bekannt und braucht hier nicht weiter erläutert zu werden.

## Patentansprüche

1. Bedieneinrichtung (20) für ein Elektrogerät, insbesondere ein Kochfeld (11), wobei die Bedieneinrichtung (20) aufweist:
- eine Bedienblende (12), insbesondere gebildet durch eine Kochfeldplatte,
- kapazitive Berührungsschalter (23) an der Bedienblende (12) entlang einer ersten Linie (L1), wobei jeder kapazitive Berührungsschalter (23) von einem kapazitiven Sensorelement (25) unter der Bedienblende (12) gebildet ist und einen kapazitiven Berührungsbereich (24) oben an der Bedienblende (12) über dem kapazitiven Sensorelement (25) aufweist,
- optische Berührungsschalter (31) an der Bedienblende (12) entlang einer zweiten Linie (L2) neben und parallel zu der ersten Linie (L1) der kapazitiven Berührungsschalter (23), wobei jeder optische Berührungsschalter (31) einen optischen Berührungsbereich (32) oben an der Bedienblende (12) aufweist,
**gekennzeichnet durch** einen Abstand von 1 mm bis 30 mm zwischen der ersten Linie (L1) und der zweiten Linie (L2),
wobei ein Abstand zwischen benachbarten optischen Berührungsschaltern (31) entlang der zweiten Linie (L2) gleich oder größer ist als ein Abstand zwischen benachbarten kapazitiven Berührungsschaltern (23) entlang der ersten Linie (L1), wobei vorzugsweise der Abstand mindestens doppelt so groß ist.

2. Bedieneinrichtung nach Anspruch 1, **dadurch gekennzeichnet, dass** der kapazitive Berührungsbereich (24) größer ist als der optische Berührungsbereich (32).

3. Bedieneinrichtung nach Anspruch 1 oder 2, **dadurch gekennzeichnet, dass** die kapazitiven Berührungsbereiche (24) jeweils bis zur zweiten Linie (L2) der optischen Berührungsschalter (31) reichen bzw. darüber hinaus reichen, insbesondere mindestens 25% des Abstands der beiden Linien (L1, L2) darüber hinaus reichen, wobei vorzugsweise die optischen Berührungsbereiche (32) nicht bis zur ersten Linie (L1) der kapazitiven Berührungsbereiche (24) reichen.

4. Bedieneinrichtung nach einem der vorhergehenden Ansprüche, **dadurch gekennzeichnet, dass** hinter der ersten Linie (L1) mit kapazitiven Berührungsschaltern (23) die zweite Linie (L2) mit den optischen Berührungsschaltern (31) verläuft, wobei hinter der zweiten Linie (L2) eine dritte Linie (L3) mit kapazitiven Berührungsschaltern (41) parallel dazu verläuft, wobei vorzugsweise in der dritten Linie (L3) genauso viele kapazitive Berührungs-schalter (41) und/oder mit demselben Abstand wie in der ersten Linie (L1) angeordnet sind, wobei insbesondere hinter der dritten Linie (L3) eine vierte Linie (L4) mit optischen Berührungsschaltern (31) parallel verläuft, vorzugsweise mit genauso vielen optischen Berührungsschaltern (31) und/oder gleichem Abstand wie bei der zweiten Linie (L2), wobei insbesondere alle optischen Berührungsschalter (31) gleich ausgebildet sind.

5. Bedieneinrichtung nach einem der vorhergehenden Ansprüche, **dadurch gekennzeichnet, dass** entlang der ersten Linie (L1) mit kapazitiven Berührungsschaltern (23) zwischen 5 und 15 kapazitive Berührungsschalter (23) bzw. kapazitive Sensorelemente (25) angeordnet sind.

6. Bedieneinrichtung nach einem der vorhergehenden Ansprüche, **dadurch gekennzeichnet, dass** entlang der zweiten Linie (L2) mit optischen Berührungsschaltern (31) zwischen 2 und 7 optische Berührungsschalter (31) angeordnet sind und/oder weniger optische Berührungsschalter (31) entlang der zweiten Linie (L2) angeordnet sind als kapazitive Berührungsschalter (23) entlang der ersten Linie (L1), vorzugsweise weniger als halb so viele optische Berührungsschalter (31) entlang der zweiten Linie (L2) angeordnet sind wie kapazitive Berührungsschalter (23) entlang der ersten Linie (L1).

7. Bedieneinrichtung nach einem der vorhergehenden Ansprüche, **dadurch gekennzeichnet, dass** die kapazitiven Sensorelemente (25) als elektrisch leitfähige Flächen unterhalb der Bedienblende (12) ausgebildet sind, wobei vorzugsweise die elektrisch leitfähigen Flächen als separate Bauteile ausgebildet sind und an die Unterseite (14) der Bedienblende (12) angelegt oder angedrückt sind.

8. Bedieneinrichtung nach einem der vorhergehenden Ansprüche, **dadurch gekennzeichnet, dass** die optischen Berührungsschalter (31) als Reflex-Lichtschranken mit einem Lichtsender (36) und einem Lichtempfänger (38) ausgebildet sind, wobei insbesondere pro optischem Berührungsschalter (31) genau ein Lichtsender (36) und/oder genau ein Lichtempfänger (38) vorgesehen ist, wobei vorzugsweise alle optischen Berührungsschalter (31) gleich ausgebildet sind, insbesondere mit Lichtsender (36) und Lichtempfänger (38) in einem Bauteilgehäuse (33).

9. Bedieneinrichtung nach einem der vorhergehenden Ansprüche, **dadurch gekennzeichnet, dass** die optischen Berührungsschalter (31) mit Licht im nicht-sichtbaren Bereich arbeiten, insbesondere mit IR-Licht.

10. Bedieneinrichtung nach einem der vorhergehenden Ansprüche, **dadurch gekennzeichnet, dass** die Linien (L1 - L4) mit kapazitiven Berührungsschaltern (23) und mit optischen Berührungsschaltern (31) gerade sind.

11. Bedieneinrichtung nach Anspruch 1, **dadurch gekennzeichnet, dass** vor der ersten Linie (L1) mit kapazitiven Berührungsschaltern (23) in einer Linie Leuchtanzeigen und/oder auf die Bedienblende (12) aufgedruckte Symbole oder Zeichen angeordnet sind, wobei vor der Linie der Leuchtanzeigen bzw. Symbole eine weitere Vor-Linie mit kapazitiven Berührungsschaltern angeordnet ist, die parallel ist zu der ersten Linie (L1) mit kapazitiven Berührungsschaltern (23), wobei vorzugsweise der Abstand zwischen der ersten Linie (L1) mit kapazitiven Berührungsschaltern (23) und der Linie mit Leuchtanzeigen bzw. Symbolen gleich groß ist wie der Abstand von der davor angeordneten weiteren Vor-Linie mit kapazitiven Berührungsschaltern zu der Linie mit Leuchtanzeigen bzw. Symbolen.

12. Bedieneinrichtung nach einem der vorhergehenden Ansprüche, **dadurch gekennzeichnet, dass** von vorne beginnend zwingend eine Linie (L1) mit kapazitiven Berührungsschaltern (23) vorgesehen ist bzw. die erste Linie (L1) mit kapazitiven Berührungsschaltern (23) die vordersten Berührungsschalter der Bedieneinrichtung (20) bilden.

13. Bedieneinrichtung nach einem der vorhergehenden Ansprüche, **dadurch gekennzeichnet, dass** sie eine Steuerung aufweist, wobei die Steuerung derart ausgebildet ist, dass
- bei einer Betätigung bzw. einer Berührung mit einem Finger (F) an der Bedienblende (12) oberhalb eines kapazitiven Berührungsschalters (23) in dessen kapazitivem Berührungsbereich (24) entlang der ersten Linie (L1) an in der Linie (L2) daneben angeordneten optischen Berührungsschaltern (31) bzw. deren optischem Berührungsbereich (32) keinerlei Erkennung der Berührung erfolgt,
- bei einer Betätigung bzw. einer Berührung mit einem Finger (F) an der Bedienblende (12) oberhalb eines optischen Berührungsschalters (31) in dessen optischem Berührungsbereich (32) entlang der zweiten Linie (L2) in der Linie (L1, L3) daneben angeordnete, insbesondere direkt daneben angeordnete, kapazitive Berührungsschalter (23) eine abgeschwächte Betätigung erkennen.

14. Elektrogerät mit einer Bedieneinrichtung (20) nach einem der vorhergehenden Ansprüche, **dadurch gekennzeichnet, dass** die Bedienblende (12) der Bedieneinrichtung (20) eine Oberseite oder eine Vorderseite des Elektrogeräts ist, wobei vorzugsweise das Elektrogerät ein Kochfeld (11) ist und die Bedienblende (12) eine Kochfeldplatte des Kochfelds (11) ist.

15. Elektrogerät nach Anspruch 14, **dadurch gekennzeichnet, dass** die Linien (L1 - L4) parallel zu einer Kante der Bedienblende (12) sind, vorzugsweise parallel zu einer Vorderkante der Kochfeldplatte eines Kochfelds (11) sind.

## Claims

1. Operating device (20) for an electrical appliance, in particular a cooking hob (11), the operating device (20) having:
- a control panel (12), in particular formed by a hob plate,
- capacitive touch switches (23) on the control panel (12) along a first line (L1), each capacitive touch switch (23) being formed by a capacitive sensor element (25) under the control panel (12) and has a capacitive touch area (24) at the top of the control panel (12) above the capacitive sensor element (25),
- optical touch switches (31) on the control panel (12) along a second line (L2) next to and parallel to the first line (L1) of capacitive touch switches (23), each optical touch switch (31) having an optical touch area (32) at the top of the control panel (12),
**characterized by** a distance of 1 mm to 30 mm between the first line (L1) and the second line (L2),
wherein a distance between adjacent optical touch switches (31) along the second line (L2) is equal to or greater than a distance between adjacent capacitive touch switches (23) along the first line (L1), preferably wherein said distance is at least twice as great.

2. Operating device according to claim 1, **characterized in that** the capacitive touch region (24) is larger than the optical touch region (32).

3. Operating device according to claim 1 or 2, **characterized in that** the capacitive touch regions (24) each extend as far as or further than the second line (L2) of the optical touch switches (31), in particular at least 25% of the distance between the two lines (L1, L2) extend beyond them, with the optical touch areas (32) preferably not extending as far as the first line (L1) of the capacitive touch areas (24).

4. Operating device according to one of the preceding claims, **characterized in that** the second line (L2) with the optical touch switches (31) runs behind the first line (L1) with capacitive touch switches (23), a third line (L3) with capacitive touch switches (41) runs parallel to it, preferably with the same number of capacitive touch switches (41) and/or the same spacing as in the first line (L1) being arranged in the third line (L3), in particular with a fourth line (L4) with optical touch switches (31) running parallel behind the third line (L3 ) a fourth line (L4) with optical touch switches (31) runs parallel, preferably with the same number of optical touch switches (31) and/or the same spacing as in the second line (L2), in particular all the optical touch switches (31) being of the same design.

5. Operating device according to one of the preceding claims, **characterized in that** between 5 and 15 capacitive touch switches (23) or capacitive sensor elements (25) are arranged along the first line (L1) with capacitive touch switches (23).

6. Operating device according to one of the preceding claims, **characterized in that** between 2 and 7 optical touch switches (31) are arranged along the second line (L2) with optical touch switches (31), and/or fewer optical touch switches (31) are arranged along the second line ( L2) than capacitive touch switches (23) are arranged along the first line (L1), preferably fewer than half as many optical touch switches (31) are arranged along the second line (L2) as capacitive touch switches (23) are arranged along the first line (L1).

7. Operating device according to one of the preceding claims, **characterized in that** the capacitive sensor elements (25) are designed as electrically conductive surfaces below the operating panel (12), with the electrically conductive surfaces preferably being designed as separate components and being placed on or pressed against the underside (14) of the operating panel (12).

8. Operating device according to one of the preceding claims, **characterized in that** the optical touch switches (31) are designed as reflex light barriers having a light emitter (36) and a light receiver (38), in particular exactly one light emitter (36) and/or exactly one light receiver (38) is/are provided, preferably all optical touch switches (31) being of the same design, in particular having a light emitter (36) and a light receiver (38) in a component housing (33).

9. Operating device according to one of the preceding claims, **characterized in that** the optical touch switches (31) operate using light in the non-visible range, in particular using IR light.

10. Operating device according to one of the preceding claims, **characterized in that** the lines (L1-L4) with capacitive touch switches (23) and with optical touch switches (31) are straight.

11. Operating device according to claim 1, **characterized in that** arranged in front of the first line (L1) with capacitive touch switches (23) are luminous displays in a line and/or symbols or characters printed on the control panel (12), wherein arranged in front of the line of luminous displays or symbols is a further front line with capacitive touch switches, which is parallel to the first line (L1) with capacitive touch switches (23), wherein preferably the distance between the first line (L1) with capacitive touch switches (23) and the line with luminous displays or symbols is the same as the distance from the further pre-line with capacitive touch switches arranged in front of it to the line with luminous displays or symbols.

12. Operating device according to one of the preceding claims, **characterized in that** a line (L1) with capacitive touch switches (23) is necessarily provided starting from the front, or the first line (L1) with capacitive touch switches (23) forms the front-most touch switches of the operating device (20).

13. Operating device according to one of the preceding claims, **characterized in that** it has a controller, the controller being designed in such a way that
- when the operating panel (12) is actuated or touched with a finger (F) at a capacitive touch switch (23) in its capacitive touch region (24) along the first line (L1) on optical touch switches (31) arranged in the line (L2) next to it or their optical touch area (32), no detection of the touch occurs,
- when the control panel (12) is actuated or touched with a finger (F) above an optical touch switch (31) in its optical touch area (32), capacitive touch switches (23) arranged in the line (L1, L3) next to it, in particular arranged directly next to it, detect a weakened actuation along the second line (L2).

14. Electrical appliance having an operating device (20) according to one of the preceding claims, **characterized in that** the operating panel (12) of the operating device (20) is a top side or a front side of the electrical appliance, with the electrical appliance preferably being a cooking hob (11) and the operating panel (12) being a hob plate of the cooking hob (11).

15. Electrical appliance according to claim 14, **characterized in that** the lines (L1-L4) are parallel to an edge of the operating panel (12), preferably parallel to a front edge of the hob plate of a cooking hob (11).

## Revendications

1. Dispositif de commande (20) pour un appareil électrique, en particulier une table de cuisson (11), le dispositif de commande (20) présentant :
- un panneau de commande (12), formé notamment par une plaque de cuisson,
- des commutateurs tactiles capacitifs (23) sur le panneau de commande (12) le long d'une première ligne (L1), chaque commutateur tactile capacitif (23) étant formé par un élément capteur capacitif (25) sous le panneau de commande (12) et présentant une zone tactile capacitive (24) en haut du panneau de commande (12) au-dessus de l'élément capteur capacitif (25),
- des commutateurs tactiles optiques (31) sur le panneau de commande (12) le long d'une deuxième ligne (L2) adjacente et parallèle à la première ligne (L1) des commutateurs tactiles capacitifs (23), chaque commutateur tactile optique (31) ayant une zone de contact optique (32) en haut du panneau de commande (12),
**caractérisé par** une distance de 1 mm à 30 mm entre la première ligne (L1) et la deuxième ligne (L2),
une distance entre des commutateurs tactiles optiques adjacents (31) le long de la deuxième ligne (L2) étant égale ou supérieure à une distance entre des commutateurs tactiles capacitifs adjacents (23) le long de la première ligne (L1), la distance étant de préférence au moins deux fois plus grande.

2. Dispositif de commande selon la revendication 1, **caractérisé en ce que** la zone tactile capacitive (24) est plus grande que la zone de contact optique (32).

3. Dispositif de commande selon la revendication 1 ou 2, **caractérisé en ce que** les zones tactiles capacitives (24) s'étendent respectivement jusqu'à la deuxième ligne (L2) des commutateurs tactiles optiques (31) ou au-delà, en particulier au moins 25% de la distance des deux lignes (L1, L2) au-delà, les zones de contact optique (32) ne s'étendant de préférence pas jusqu'à la première ligne (L1) des zones tactiles capacitives (24).

4. Dispositif de commande selon l'une des revendications précédentes, **caractérisé en ce que** derrière la première ligne (L1) avec des commutateurs tactiles capacitifs (23) s'étend la deuxième ligne (L2) avec les commutateurs tactiles optiques (31), une troisième ligne (L3) avec des commutateurs tactiles capacitifs (41) s'étendant parallèlement à la deuxième ligne (L2), de préférence, dans la troisième ligne (L3), autant de commutateurs tactiles capacitives (41) et/ou avec le même espacement que dans la première ligne (L1), en particulier, derrière la troisième ligne (L3), une quatrième ligne (L4) avec des commutateurs tactiles optiques (31) s'étendant parallèlement, de préférence avec autant de commutateurs tactiles optiques (31) et/ou le même espacement que pour la deuxième ligne (L2), en particulier, tous les commutateurs tactiles optiques (31) étant conçus de manière identique.

5. Dispositif de commande selon l'une des revendications précédentes, **caractérisé en ce que** le long de la première ligne (L1) avec des commutateurs tactiles capacitifs (23), entre 5 et 15 commutateurs tactiles capacitifs (23) ou éléments de détection capacitifs (25) sont disposés.

6. Dispositif de commande selon l'une des revendications précédentes, **caractérisé en ce que** le long de la deuxième ligne (L2) avec des commutateurs tactiles optiques (31) entre 2 et 7 commutateurs tactiles optiques (31) sont disposés et/ou moins de commutateurs tactiles optiques (31) sont disposés le long de la deuxième ligne (L2) que de commutateurs tactiles capacitifs (23) le long de la première ligne (L1), de préférence, moins de la moitié des commutateurs tactiles optiques (31) sont disposés le long de la deuxième ligne (L2) que les commutateurs tactiles capacitifs (23) le long de la première ligne (L1).

7. Dispositif de commande selon l'une des revendications précédentes, **caractérisé en ce que** les éléments de détection capacitifs (25) sont réalisés sous forme de surfaces électriquement conductrices sous le panneau de commande (12), les surfaces électriquement conductrices étant de préférence réalisées sous forme de composants séparés et étant appliquées ou pressées contre la face inférieure (14) du panneau de commande (12).

8. Dispositif de commande selon l'une des revendications précédentes, **caractérisé en ce que** les commutateurs tactiles optiques (31) sont réalisés sous forme de barrières lumineuses à réflexion avec un émetteur de lumière (36) et un récepteur de lumière (38), un émetteur de lumière (36) et/ou un récepteur de lumière (38) étant notamment prévus par commutateur tactile optique (31), tous les commutateurs tactiles optiques (31) étant de préférence réalisés de manière identique, notamment avec un émetteur de lumière (36) et un récepteur de lumière (38) dans un boîtier de composant (33).

9. Dispositif de commande selon l'une des revendications précédentes, **caractérisé en ce que** les commutateurs tactiles optiques (31) fonctionnent avec de la lumière dans la zone non visible, en particulier avec de la lumière IR.

10. Dispositif de commande selon l'une des revendications précédentes, **caractérisé en ce que** les lignes (L1 - L4) sont droites avec des commutateurs tactiles capacitifs (23) et avec des commutateurs tactiles optiques (31).

11. Dispositif de commande selon la revendication 1, **caractérisé en ce qu'**avant la première ligne (L1) avec des commutateurs tactiles capacitifs (23), des affichages lumineux et/ou des symboles ou signes imprimés sur le panneau de commande (12) sont disposés sur une ligne, la ligne des affichages lumineux ou des symboles étant précédée d'une pré-ligne. symboles, une autre pré-ligne avec des commutateurs tactiles capacitifs est disposée parallèlement à la première ligne (L1) avec des commutateurs tactiles capacitifs (23), la distance entre la première ligne (L1) avec des commutateurs tactiles capacitifs (23) et la ligne avec des affichages lumineux ou des symboles étant de préférence aussi grande que la distance entre l'autre pré-ligne avec des commutateurs tactiles capacitifs disposée devant et la ligne avec des affichages lumineux ou des symboles.

12. Dispositif de commande selon l'une des revendications précédentes, **caractérisé en ce que**, en commençant par l'avant, il est obligatoirement prévu une ligne (L1) avec des commutateurs tactiles capacitifs (23) ou la première ligne (L1) avec des commutateurs tactiles capacitifs (23) forme les interrupteurs tactiles les plus en avant du dispositif de commande (20).

13. Dispositif de commande selon l'une des revendications précédentes, **caractérisé en ce qu'**il comporte une commande, la commande étant conçue de telle sorte que
- lors d'un actionnement ou d'un contact avec un doigt (F) sur le panneau de commande (12) au-dessus d'un commutateur tactile capacitif (23) dans sa zone de contact capacitive (24) le long de la première ligne (L1), aucune reconnaissance du contact n'est effectuée sur des commutateurs tactiles optiques (31) disposés à côté dans la ligne (L2) ou sur leur zone de contact optique (32),
- lors d'un actionnement ou d'un contact avec un doigt (F) sur le panneau de commande (12) au-dessus d'un commutateur tactile optique (31) dans sa zone de contact optique (32) le long de la deuxième ligne (L2) dans la ligne (L1, L3), des commutateurs tactiles capacitifs (23) disposés à côté, en particulier directement à côté, reconnaissent un actionnement affaibli.

14. Appareil électrique avec un dispositif de commande (20) selon l'une des revendications précédentes, **caractérisé en ce que** le panneau de commande (12) du dispositif de commande (20) est une face supérieure ou une face avant de l'appareil électrique, l'appareil électrique étant de préférence une table de cuisson (11) et le panneau de commande (12) étant une plaque de cuisson de la table de cuisson (11).

15. Appareil électrique selon la revendication 14, **caractérisé en ce que** les lignes (L1 - L4) sont parallèles à un bord du panneau de commande (12), de préférence parallèles à un bord avant de la plaque de cuisson d'une table de cuisson (11).
